# EUROPEAN PATENT APPLICATION

(11) **EP 3 696 826 A1**
(43) Date of publication of application: **19.08.2020**
(21) Application number: 18867157.2
(22) Date of filing: 12.10.2018
(51) Int. Cl.: H01B 12/06, H01F 6/06, H01R 4/68

(54) **CONNECTION STRUCTURE FOR OXIDE SUPERCONDUCTING WIRE MATERIALS**

(30) Priority: 13.10.2017 JP 2017199283
(71) Applicant: Fujikura Ltd., Tokyo 135-8512 (JP)
(72) Inventor: NAKAMURA Naonori, Sakura-shi Chiba 285-8550 (JP)
(74) Representative: Plasseraud IP
(86) International application number: PCT/JP2018/038105
(87) International publication number: WO 2019/074100

(57) **Abstract**

An oxide superconducting wire connection structure is provided in which connection target wires each including an oxide superconducting wire including a superconducting layer on a substrate are connected via connection superconducting wires narrower in width than the connection target wires; and current characteristics of the connection superconducting wires are equal to or greater than current characteristics of the connection target wires.

## Description

### TECHNICAL FIELD

The present invention relates to an oxide superconducting wire connection structure.

This application claims priority based on Japanese Patent Application No. 2017-199283 filed in Japan on October 13, 2017, the contents of which are incorporated herein by reference.

### BACKGROUND ART

Oxide superconducting wires are used as power supply cables, magnetic coils and the like because of their low current loss. Currently, since oxide superconducting wires are produced through a number of processes, it is difficult to produce a defect-free long wire suitable for the above- mentioned usage. For this reason, the wire of the length suitable for the above-mentioned usage is constituted by connecting a plurality of wires. In addition, in order to apply to a coil used for an MRI, an NMR, and the like among magnetic coils, it is desired to connect both ends in a loop shape with a low resistance to enable operation in a permanent current mode. Patent Document 1 describes a connection structure in which a groove leading to the outside is provided in at least one of the superconducting wires.

### PRIOR ART DOCUMENTS

### PATENT DOCUMENTS

[Patent Document 1] Japanese Unexamined Patent Application, First Publication No. 2016-201328

### DISCLOSURE OF INVENTION

### PROBLEMS TO BE SOLVED BY THE INVENTION

In the case of the connection structure described in Patent Document 1, since oxygen is supplied through the groove during an oxygen annealing process, the groove needs to be continuously formed in the longitudinal direction. For this reason, the width of a superconducting layer becomes narrow and the current characteristics in a connection structure becomes lower than the current characteristics of the wire in portions other than a connection structure. As a result, the current characteristics in the connection structure is the upper limit of the current characteristics of the long wire obtained by connecting a plurality of wires.

The present invention is made in view of the above-mentioned circumstances, and provides a connection structure of an oxide superconducting wire which can improve the current characteristics in a connection structure.

### SUMMARY OF THE INVENTION

A first aspect of the present invention is an oxide superconducting wire connection structure, in which connection target wires each including an oxide superconducting wire including a superconducting layer on a substrate are connected via connection superconducting wires narrower in width than the connection target wires; and current characteristics of the connection superconducting wires are equal to or greater than current characteristics of the connection target wires.

A second aspect of the present invention is that, in the oxide superconducting wire connection structure according to the first aspect described above, two or more connection superconducting wires are arranged, and current characteristics obtained by summing current characteristics of two or more of the connection superconducting wires is equal to or greater than current characteristics of the connection target wire.

A third aspect of the present invention is that, in the oxide superconducting wire connection structure according to the second aspect described above, a gap is provided so that two or more of the connection superconducting wires are non-contact in the width direction.

A fourth aspect of the present invention is that, in the oxide superconducting wire connecting structure according to any one of the first to third aspects, the connection superconducting wire comprises an oxide superconducting wire including a superconducting layer on a substrate, and the superconducting layer has (1) a better crystal orientation than a superconducting layer of the connection target wire, (2) a film thickness is larger than a superconducting layer of a connection target wire, (3) an artificial crystal defect, or (4) a combination of two or more of the above-described (1) to (3).

### EFFECTS OF THE INVENTION

According to the aspects of the present invention described above, the current characteristics in the connection structure of the oxide superconducting wire can be improved.

### BRIEF DESCRIPTION OF THE DRAWINGS

FIG. 1 is a perspective view which shows an embodiment of a connection structure of an oxide superconducting wire of the present invention.
FIG. 2 is a sectional view taken along the line II-II in FIG. 1.

### DESCRIPTION OF THE PREFERRED EMBODIMENTS

Hereinafter, based on a preferred embodiment, the present invention will be described with reference to the drawings. The drawings are schematic diagrams, and the dimensional ratios of the respective components are not necessarily the same as the actual dimensional ratios.

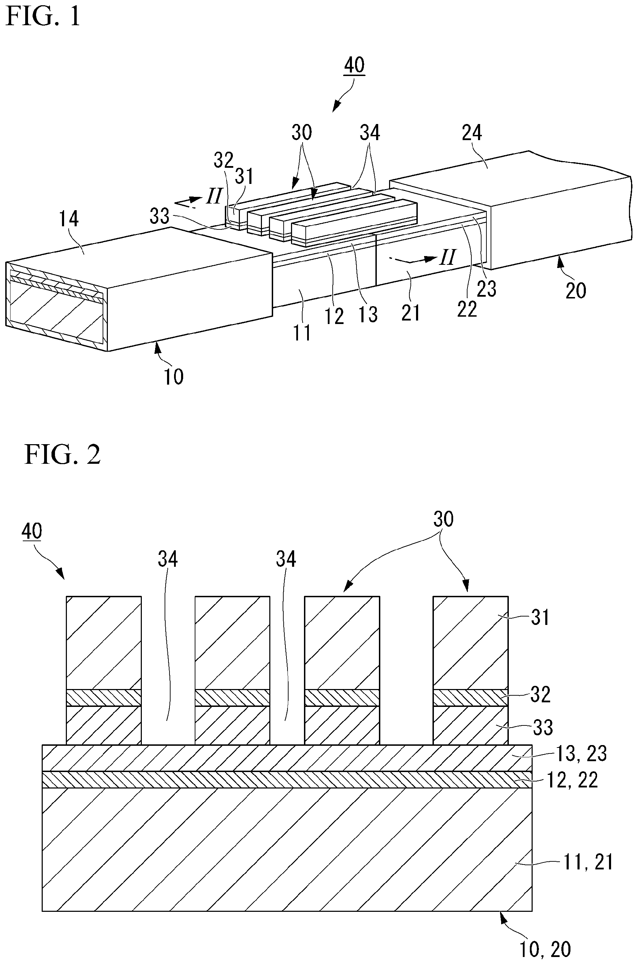

In FIG. 1, a perspective view of the connection structure of an embodiment is shown. In FIG. 2, a cross- sectional view in a direction perpendicular to the longitudinal direction of the connection structure is shown.

The connection structure 40 has a structure in which two connection target wires 10 and 20 are connected via connection superconducting wires 30.

The connection target wires 10 has an oxide superconducting wire having superconducting layers 13 on the respective substrates 11. The connection target wires 20 has an oxide superconducting wire having superconducting layers 23 on the respective substrates 21. The connection target wires 10 has a laminated structure in which superconducting layer 13 is formed on one main surface of the substrates 11 via the intermediate layers 12. The connection target wires 20 has a laminated structure in which superconducting layer 23 is formed on one main surface of the substrates 21 via the intermediate layers 22.

In addition, the connection superconducting wire 30 of the present embodiment includes an oxide superconducting wire having a superconducting layer 33 on a substrate 31. The connection superconducting wire 30 has a laminated structure in which a superconducting layer 33 is formed on one main surface of a substrate 31 via an intermediate layer 32.

Protection layers 14 and 24 having metal or the like are formed around the connection target wires 10 and 20, respectively.

In the connection structure 40 of the present embodiment, the connection target wires 10 and 20 are arranged so that end portions in the longitudinal direction are opposed to each other in the longitudinal direction. The end portions in the longitudinal direction of the connection target wire 10 and 20 may be brought into contact with each other, or a gap may be provided between the end portions in the longitudinal direction of the connection target wire 10 and 20. On the main surfaces of the substrates 11 and 21, the direction intersecting the longitudinal direction is the width direction.

In the connection superconducting wire 30, the superconducting layer 33 is arranged so as to face and overlap the superconducting layers 13 and 23 of the respective connection target wires 10 and 20. As a result, the connection target wires 10 and 20 are connected via the connection superconducting wire 30. The superconducting layer 13 of the connection target wire 10 and the superconducting layer 33 of the connection superconducting wire 30, and the superconducting layer 23 of the connection target wire 20 and the superconducting layer 33 are preferably in contact or integrated so that superconducting connection is possible.

For this reason, a material having a greater electrical resistance than the superconducting layers 13, 23, and 33, such as solder, is preferably not interposed between the superconducting layer 13 of the connection target wire 10 and the superconducting layer 33 of the connection superconducting wire 30, and between the superconducting layer 23 of the connection target wire 20 and the superconducting layer 33.

The connection superconducting wire 30 is narrower than the connection target wires 10 and 20. Thereby, a portion of the superconducting layers 13 and 23 of the respective connection target wires 10, 20 is exposed without being covered with superconducting layer 33 of connection superconducting wire 30. In the present embodiment, there are two or more connection superconducting wires 30, and a gap 34 is provided so that the connection superconducting wires 30 do not contact in the width direction.

In the connection structure 40 of the present embodiment, the current characteristics of the connection superconducting wire 30 are equal to or greater than the current characteristics of the connection target wires 10 and 20. Thereby, the current characteristics of the connection structure 40 are not limited to the current characteristics of the connection superconducting wires 30, and become equal to or greater than the current characteristics of the connection target wires 10 and 20. Specific examples of current characteristics include critical current (Ic) below the critical magnetic field.

When two or more connection superconducting wires 30 are provided in parallel in the width direction, the current characteristics of each of the connection superconducting wires 30 may not be equal to or greater than the current characteristics of the connection target wires 10 and 20. The current characteristics obtained by adding two or more connection superconducting wires 30 may be equal to or greater than the current characteristics of the connection target wires 10 and 20.

When there is a difference in the current characteristics of the connection target wires 10 and 20, it is preferable that the current characteristics of the connection superconducting wire 30 are at least equal to or greater than the lower current characteristics of the connection target wires 10 and 20. The current characteristics of the connection superconducting wire 30 may be equal to or greater than the average current characteristics of the connection target wires 10 and 20, or may be equal to or greater than the greater current characteristics of the connection target wires 10 and 20.

As a method of improving the current characteristics of the connection superconducting wire 30, for example, the following (1) to (3) or a combination of two or more of these can be provided.
(1) The superconducting layer 33 of the connection superconducting wire 30 has an oxide superconductor having a better crystal orientation as compared with the superconducting layers 13 and 23 of the respective connection target wires 10 and 20.
(2) The film thickness of the superconducting layer 33 of the connection superconducting wire 30 is thicker than the film thickness of the superconducting layers 13 and 23 of the respective connection target wires 10 and 20.
(3) The superconducting layer 33 of the connection superconducting wire 30 includes artificial crystal defects.

In the case (3), the superconducting layers 13 and 23 of the respective connection target wires 10 and 20 are not limited to the case where artificial crystal defects are not included, and the artificial crystal defects may be included. When all the superconducting layer 33 of the connection superconducting wire 30 and the superconducting layers 13 and 23 of the respective connection target wires 10 and 20 include the artificial crystal defects, due to a difference in the type or degree of the artificial crystal defects, the above-described (1), (2) or the like, a difference in current characteristics can be provided.

In the superconducting layer 33 of the connection superconducting wire 30, as an oxide superconductor having a good crystal orientation, for example, the orientation of the intermediate layer 32 of the connection superconducting wire 30 is greater than the intermediate layer 12 and 22 of the respective connection target wires 10 and 20. As the oxide superconductor constituting the superconducting layer 33 of the connection superconducting wire 30, a material having greater current characteristics than the oxide superconductor constituting the superconducting layers 13 and 23 of the respective connection target wires 10 and 20 may be used. The superconducting layers 13 and 23 of the respective connection target wires 10 and 20 are preferably a long and stable material, and the superconducting layer 33 of the connection superconducting wire 30 is preferably a short material having high current characteristics.

Examples of the artificial crystal defects include artificial pins made of different materials. Examples of the different materials used for introducing the artificial pin into the superconducting layer include one kind or two or more kinds of BaSnO₃(BSO), BaZrO₃(BZO), BaHfO₃(BHO), BaTiO₃ (BTO), SnO₂, TiO₂, ZrO₂, LaMnO₃, ZnO, and the like.

Next, the oxide superconducting wire constituting the connection target wires 10 and 20 and the connection superconducting wire 30 will be described.

The substrates 11, 21, and 31 are tape-shaped metal substrates. Each substrate has main surfaces on both sides in the thickness direction. Specific examples of the metal constituting each substrate include nickel alloys such as Hastelloy (registered trademark), stainless steel, and oriented NiW alloys in which a texture is introduced into the nickel alloy. The thickness of the substrate may be appropriately adjusted according to the purpose, and is, for example, in the range of 10 to 1000 µm.

The intermediate layer 12 is provided between the substrate 11 and the superconducting layer 13. The intermediate layer 22 is provided between the substrate 21 and the superconducting layer 23. The intermediate layer 32 is provided between the substrate 31 and the superconducting layer 33. The intermediate layer may have a multilayer structure, and may include, for example, a diffusion prevention layer, a bed layer, an alignment layer, a cap layer, and the like in order from the substrate side to the superconducting layer side. These layers are not necessarily provided one by one, and some layers may be omitted, or two or more of the same kind of layers may be laminated repeatedly.

The superconducting layers 13, 23, and 33 are constituted by an oxide superconductor. Examples of the oxide superconductor include a RE-Ba-Cu-O-based oxide superconductor represented by a general formula REBa₂Cu₃O7-x (RE123). Examples of the rare earth element RE include one kind or two or more kinds of Y, La, Ce, Pr, Nd, Sm, Eu, Gd, Tb, Dy, Ho, Er, Tm, Yb, and Lu. The thickness of the oxide superconducting layer is, for example, appropriately 0.5 to 5 µm.

The protection layers 14 and 24 have functions such as bypassing overcurrent and reducing a chemical reaction that occurs between the superconducting layers 13, 23, and 33 and the layers provided on the protection layers 14 and 24. Examples of the material of the protection layers 14 and 24 include silver (Ag), copper (Cu), gold (Au), an alloy of gold and silver, other silver alloys, copper alloys, and gold alloys. The thickness of the protection layers 14 and 24 is, for example, approximately 1 to 30 µm. When the protection layers 14 and 24 are thinned, the thickness may be 10 µm or less.

Two or more protection layers 14 and 24 can be laminated in the thickness direction. For example, silver or a silver alloy that can transmit oxygen under high temperature conditions is laminated as the protection layers 14 and 24 before the oxygen annealing, and copper or the like may be laminated on the silver or silver alloy after the oxygen annealing. After the oxygen annealing, a metal layer similar to the protection layers 14 and 24 may be provided around the connection target wires 10 and 20, respectively, or the connection superconducting wire 30 in the connection structure 40 to coat the superconducting layers 13, 23, and 33 and the like. A stabilization layer (not shown) or the like may be provided on the protection layers 14 and 24. Examples of the stabilization layer include a plating layer of metal such as Cu, Ag, Al, Sn, Ti, and an alloy, or a metal foil. The stabilization layer may be constituted by laminating the two or more kinds of the above.

As a manufacturing method of the connection structure 40, the connection target wire 10 having the intermediate layers 12 and the superconducting layer 13 on the substrate 11 is manufactured, and the connection target wire 20 having the intermediate layers 22 and the superconducting layer 23 on the substrate 21 is manufactured. After laminating the protection layers 14 and 24 around the respective connection target wires 10 and 20 including at least the upper surface of the superconducting layers 13 and 23, respectively, the superconducting layers 13 and 23 of the respective connection target wires 10 and 20 are connected via the superconducting layer 33 of the connection superconducting wire 30.

In the connection target wires 10 and 20 before the connection, when the protection layers 14 and 24 are formed on the respective superconducting layers 13 and 23 where the connection superconducting wire 30 is overlapped, it is preferable to remove at least a portion of the overlapped portion of the protection layers 14 and 24.

After the superconducting layers 13 and 23 of the respective connection target wires 10 and 20 are overlapped on superconducting layer 33 of connection superconducting wire 30, the superconductor may be diffusion-bonded in order to reduce the electrical resistance at an interface. In addition, the deterioration of the superconducting layers 13, 23, and 33 may be recovered by performing oxygen annealing after the connection. In the diffusion bonding, it is preferable that the superconductors included in the opposing superconducting layers be the same or similar materials. The ratio of the oxide to the metal element of the oxide superconductor can be optimized by the oxygen annealing.

If there is a gap 34 between two or more connection superconducting wires 30, oxygen can be circulated through the superconducting layers 13, 23 and 33 during the oxygen annealing after the connection. Even after the connection, the introduction of oxygen is not hindered, and the introduction of oxygen does not require a great deal of time. The oxygen annealing of the connection target wires 10 and 20 and the connection superconducting wire 30 is preferably performed at least once before or after the connection target wires 10 and 20 are connected to the connection superconducting wire 30. After connecting the wire with the superconducting layer exposed, it is preferable to laminate a protection layer of silver or the like on at least the exposed superconducting layer so that the superconducting layer is not exposed.

When there is a gap between the longitudinal ends of the connection target wires 10 and 20, or when there are gaps in two or more connection superconducting wires 30, a filler or the like (not shown) may be interposed in these gaps. Examples of the filler include metals, resins, and the like. When the superconducting layers 13 and 23 of the respective connection target wires 10 and 20 and the superconducting layer 33 of the connection superconducting wire 30 are superconductingly connected, even a conductor or an electrical insulator exists around the superconducting layers 13, 23 and 33, the superconducting properties of the wire are not affected.

As mentioned above, although the present invention has been described based on the preferable embodiments, the present invention is not limited to the above-mentioned embodiment, and a various modifications are possible in the range which does not deviate from the summary of the present invention. Examples of the modifications include addition, replacement, omission, and other changes of components in each embodiment. Moreover, it is also possible to combine the component used for two or more embodiment appropriately.

When obtaining a wire in which two or more oxide superconducting wires are connected in the longitudinal direction via the connection portion, a long connection target wire and a short connection superconducting wire may be alternately and repeatedly connected.

To fabricate a superconducting coil using an oxide superconducting wire, for example, after a wire is wound around the outer peripheral surface of a winding frame to form a coil-shaped multilayer winding coil, the wire can be fixed by impregnating with a resin such as an epoxy resin so as to cover the wound wire. A plurality of coils may be arranged in the axial direction. In such a case, since each coil is adjacent in the width direction of the wire, it is preferable that both ends in the width direction of the connection superconducting wire do not protrude from both ends in the width direction of the connection target wire.

### EXAMPLES

Hereinafter, the present invention will be specifically described with reference to examples. Here, an example is shown in which a superconducting wire having a width of 4 mm is used as a connection target wire, and ends of the connection target wire are connected in a bridge shape by four connection superconducting wires. The electrical characteristics were measured at the liquid nitrogen temperature at which the wire became superconductive.
1. Fabrication of connection target wire used in examples
   (1-1) A substrate having Hastelloy (registered trademark) C-276 having a width of 12 mm, a length of 5 m, and a thickness of 0.75 mm (750 µm) was prepared as a substrate, and the main surface of the substrate was polished using alumina (Al₂O₃) particles having an average particle diameter of 3 µm.
   (1-2) The substrate was degreased and washed with an organic solvent such as ethanol or acetone.
   (1-3) An Al₂O₃ layer having a thickness of 100 nm was formed as a diffusion prevention layer on the main surface of the substrate by an ion beam sputtering method.
   (1-4) A Y₂O₃ layer having a thickness of 30 nm was formed as a bed layer on the surface of the Al₂O₃ layer by an ion beam sputtering method.
   (1-5) An MgO layer having a thickness of 5 to 10 nm was formed as an alignment layer on the surface of the Y₂O₃ layer by an ion beam assisted deposition method.
   (1-6) A CeO₂ layer having a thickness of 500 nm was formed as a cap layer on the surface of the MgO layer by a pulse laser deposition method. An in-plane orientation degree (Δϕ) of the CeCh layer was 4.0°.
   (1-7) A GdBa₂Cu₃O_{7-X} layer having a thickness of 2 µm was formed as a superconducting layer on the surface of the CeO₂ layer by a pulse laser deposition method.
   (1-8) An Ag layer having a thickness of 2 µm was formed as a protection layer by a DC sputtering method.
   (1-9) The oxygen annealing was performed at 500°C for 10 hours, and after the furnace cooling for 26 hours, the wire was taken out from the furnace.
   (1-10) The wire was cut along the longitudinal direction with an infrared laser to obtain three connection target wires having a width of 4 mm. When the current characteristics of two of the wires were measured, the energizing current value (critical current value) at which two wires could be energized while maintaining the superconducting state was 200 A.
   (1-11) The Ag layer in a section of 7 cm in the longitudinal direction from one end of the two wires whose current characteristics were measured was dissolved to expose the superconducting layer, and then the ends were butted together.
2. Fabrication of connection superconducting wire used in examples
   (2-1) to (2-6) were carried out in the same manner as (1-1) to (1-6) described above.
   (2-7) A GdBa₂Cu₃O_{7-X} layer having a thickness of 3.5 µm was formed as a superconducting layer on the surface of the CeO₂ layer by a pulse laser deposition method.
   (2-8) to (2-9) were carried out in the same manner as (1-8) to (1-9) described above.
   (2-10) The wire was cut along the longitudinal direction with an infrared laser to obtain seventeen superconducting wires having a width of 0.68 mm. When the current characteristics of one of the wires was measured, the energization current value was 61 A.
   (2-11) Four connection superconducting wires having a length of 5 cm were obtained from one wire whose current characteristics were measured. The Ag layer was dissolved over the entire length to expose the superconducting layer.
3. Connection of superconducting wires according to examples
   (3-1) As shown in FIG. 1, the superconducting layers 13 and 23 of the connection target wires 10 and 20 respectively and the superconducting layers 33 of the four connection superconducting wires 30 were face to each other, and were overlapped while being pressed in the thickness direction. The gaps of 200 µm or more were arranged so as not to contact between the connection superconducting wires 30 adjacent in the width direction. The gap 34 is not limited as described above as long as the flow of oxygen during oxygen annealing is not hindered.
   (3-2) The facing portions of the connection target wire rods 10 and 20 and the connection superconducting wire rod 30 were arranged under a reduced pressure of 3×10⁻² Torr, and the superconducting layers 13, 23, and 33 were diffusion-bonded by irradiating an infrared laser from a side of the substrates 11 and 21 of the respective connection target wire rods 10 and 20. The laser irradiation conditions were a wavelength of 1064 nm, an energy density of 3×10⁵ W/cm², and an irradiation time of 10 seconds.
   (3-3) After taking out the wire from under reduced pressure, 1 µm of Ag was deposited on the connection portion where the superconducting layer was exposed and on the connection portion.
   (3-4) Oxygen annealing of the wire including the connection portion was performed at 500 °C for 10 hours, and after furnace cooling for 10 hours, the wire was taken out from the furnace.
   (3-5) The energizing current value and the connection resistance of the wire including the connection portion were measured. The energizing current value of the wire including the connection portion was 200 A, which was equivalent to 200 A which was the energizing current value of the connection target wire before the connection. The connection resistance was 1 nΩ or less, indicating a superconducting state.
4. Connection of superconducting wire according to comparative example
   (4-1) Connection target wires were prepared in the same manner as (1-1) to (1-11) in Examples.
   (4-2) In order to prepare the connection superconducting wire of the comparative example, after fabricating the wire in the same manner as (1-1) to (1-10) of the connection target wire of the Example, the wire was cut into 30 cm lengths. Then, the superconducting layer on the substrate was divided into four in the width direction in a section of 5 cm which was 12.5 to 17.5 cm in the longitudinal direction from the end portion. The four-section dividing processing was performed by fabricating three grooves so that the substrate was not cut by scribe processing under the conditions of the wavelength of 532 nm, the frequency of 500 kHz, the output of 12 W, the pulse width of 10 ps, the processing speed of 300 mm/s, and repeating laser irradiation three times per groove. Each groove width was 50 µm. The energizing current value of the wire after the groove processing was 192 A. After a scribe-processed 5-cm section was cut with an infrared CW laser, the Ag layer was dissolved to expose the superconducting layer to obtain a 5-cm long connection superconducting wire.
   (4-3) Both ends of the connection superconducting wire scribe-processed with a length of 5 cm were opposed to the ends of the connection target wire, and were overlapped while being pressed in the thickness direction. Both opposing end portions were arranged under a reduced pressure of 3×10⁻² Torr, and the superconducting layer was diffusion-bonded by irradiating an infrared laser from a side of the substrate of the connection target wire. The laser irradiation conditions were the wavelength of 1064 nm, the energy density of 3×10⁵ W/cm², and an irradiation time of 10 seconds.
   (4-4) After taking out the wire from under reduced pressure, 1 µm of Ag was deposited on the connection portion where the superconducting layer was exposed and on the connection portion.
   (4-5) Oxygen annealing of the wire including the connection portion was performed at 500 °C for 10 hours, and after furnace cooling for 26 hours, the wire was taken out from the furnace.
   (4-6) The energizing current value and the connection resistance of the wire including the connection portion were measured. The energizing current value of the wire including the connection portion was 192 A, which was less than 200 A, which was the energizing current value of the connection target wire before the connection. The connection resistance was 1 nΩ or less, indicating a superconducting state.

As described above, if the current characteristics of the connection target superconducting wire were equal to or greater than the current characteristics of the connection target wire, the energization current value of the wire including the connection portion was equal to the energization current value of the connection target wire before connection. Moreover, if the current characteristics of the connection target superconducting wire was lower than the current characteristics of the connection target wire, the energization current value of the wire including the connection portion was lower than the energization current value of the connection target wire before connection.

### DESCRIPTION OF SYMBOLS

10, 20: Connection target wire
11,21,31: Substrate
12, 22, 32: Intermediate layer
13, 23, 33: Superconducting layer
14, 24: Protection layer
30: Connection target superconducting wire
34: Gap
40: Connection structure

## Claims

1. An oxide superconducting wire connection structure wherein:
connection target wires each comprising an oxide superconducting wire comprising a superconducting layer on a substrate are connected via connection superconducting wires narrower in width than the connection target wires; and
current characteristics of the connection superconducting wires are equal to or greater than current characteristics of the connection target wires.

2. The oxide superconducting wire connection structure according to claim 1, wherein two or more connection superconducting wires are arranged, and current characteristics obtained by summing current characteristics of two or more of the connection superconducting wires is equal to or greater than current characteristics of the connection target wire.

3. The oxide superconducting wire connection structure according to claim 2, wherein a gap is provided so that two or more of the connection superconducting wires are non-contact in the width direction.

4. The oxide superconducting wire connection structure according to any one of claims 1-3, wherein
the connection superconducting wire comprises an oxide superconducting wire comprising a superconducting layer on a substrate, and
the superconducting layer has (1) a better crystal orientation than the superconducting layer of the connection target wire, (2) a film thickness larger than a superconducting layer of a connection target wire, (3) an artificial crystal defect, or (4) a combination of two or more of the above-described (1) to (3).
